# EUROPEAN PATENT APPLICATION

(11) **EP 1 241 921 A2**
(43) Date of publication of application: **18.09.2002**
(21) Application number: 02251184.4
(22) Date of filing: 21.02.2002
(51) Int. Cl.: H04R 25/00

(54) **Acoustic signal processor**

(30) Priority: 26.02.2001 JP 2001050274
(71) Applicant: Adphox Corporation, Oume-shi, Tokyo 198-0036 (JP)
(72) Inventor: Narusawa, Hitoshi, Oume-shi, Tokyo 198-0036 (JP)
(74) Representative: Stebbing, Timothy Charles

(57) **Abstract**

The present invention relates to an acoustic signal processor, and provides a device which allows processing of acoustic signals such that acoustic information can be easily heard and accurately understood by individuals with or without hearing impairment. The acoustic signal processor comprises a peak detection circuit group (4) for determining a frequency band having the highest energy level out of the frequency bands constituting the inputted acoustic signals, and a variable equalizer(7) which maintains the energy level roughly at a constant level for the frequency bands lower than the frequency band determined by peak detection circuit group (4), and increases the amplification degree of the energy level as the frequency increases for the frequency bands higher than the frequency band determined by the peak detection circuit group(4)

## Description

The present invention relates to an acoustic signal processor which can process acoustic signals so as to make them clear and easy to hear regardless of whether a listener has a hearing impairment or not, as well as to an acoustic signal processing method and program.

Generally when individuals perceive acoustic signals by auditory senses, the acoustic signals are detected by the auditory nerve and are transferred to the brain, where these signals are processed with reference to memory acquired from past experiences, but the functions of the auditory nerve path are little understood since the auditory nerve path is extremely long and complicated compared with the visual nerve path.

Recent advancements in electronic engineering have enabled many new endeavours in the field of acoustic processing, but some endeavours have appeared which involve processing to provide a new image of sounds by confusing the human auditory senses, and have raised concerns as to whether the human factor has been lost sight of.

The fundamental proposition of acoustic processing must be to advance it as a technology to assist in understanding based on human auditory senses, and to provide acoustic information which can easily be understood by a range of listeners having differing hearing abilities.

It is therefore desirable to provide a means for processing acoustic signals so that acoustic information can be easily heard and accurately understood whether an individual has a hearing impairment or not.

As a basis for the present invention, in order to assist understanding of information content of acoustic signals obtained by human auditory senses, only the level of sound which will be lost by the auditory senses of an individual with hearing impairment is increased. As the level-increased sound is easily heard by an individual without hearing impairment, acoustic information which is difficult to understand, such as human speech in a foreign language, can be made easy to hear.

Generally, in order to actualize the understanding of acoustic signals by the auditory senses, the distribution of important frequencies and the flow of levels are detected in the flow of acoustic signals, and the result of such is transferred to the brain. Research on such flows is relatively advanced in the field of language, where the important frequencies are called the first formant, second formant, third formant and so on.

It appears that the capability of an individual to sharply detect each formant and to perceive language is learned during infancy, and the reason why Japanese have trouble distinguishing the English sounds L and R, for example, lies in a decline in the auditory function to detect [L and R] as distinctive sounds, since no training to distinguish [L and R] was necessary during infancy, therefore in this sense, Japanese can be regarded as individuals with a minor hearing impairment in terms of hearing English.

Even if some acoustic information acquired through the auditory senses is deficient, the human brain can complement the missing acoustic information using past experience and the assistance of visual information, so if the acoustic signals comprise, e.g., speech on a topic known to an individual who hears the acoustic signals, then even somewhat inaccurate acoustic information acquired by the auditory senses will not cause major problems.

However, under conditions where past experience is lacking, it is difficult to complement acoustic information, so when listening to a foreign language, for example, acoustic information to be detected by the auditory senses must be sufficiently accurate.

For the auditory senses to recognize language, the first formant, second formant, third formant . . . are detected, and language is understood by a unique distribution thereof. Therefore if any important ones of these formants cannot be detected, then language cannot be recognized, which causes a form of hearing impairment, i.e. a state of hearing impairment for a foreign language, which involves difficulty in understanding the language.

It is unavoidable that various human functions decline due to aging, and in the case of the auditory senses, which perform advanced signal analysis, various disorders begin to occur. A minor case would be some deterioration in auditory sensitivity, as evidenced by turning up a television to hear the sound, but in a more serious case involving a further deterioration of auditory sensitivity, a state is reached in which the content of acoustic information, for example language, cannot be understood. Even if the sound level is increased, the auditory senses perceive only noise.

This is because the first formant, second formant, third formant ... cannot be separated and detected, even if the sound volume is increased.

It is well known that the auditory senses have a masking effect, where, for example, when a high level sound is generated, even an individual without hearing impairment cannot detect sounds at lower levels near the frequency thereof. Especially in the case of an aged person, whose capability of detecting acoustic information has declined, the masking range is increased, and the second formant and the third formant, which are at a lower level than the first formant, tend to be masked.

According to experiments performed by the present inventor, if the sound level is increased in the above mentioned state, the first formant increases, which further expands the masking range, and as a result, the difficulty of detecting the second formant and third formant increases.

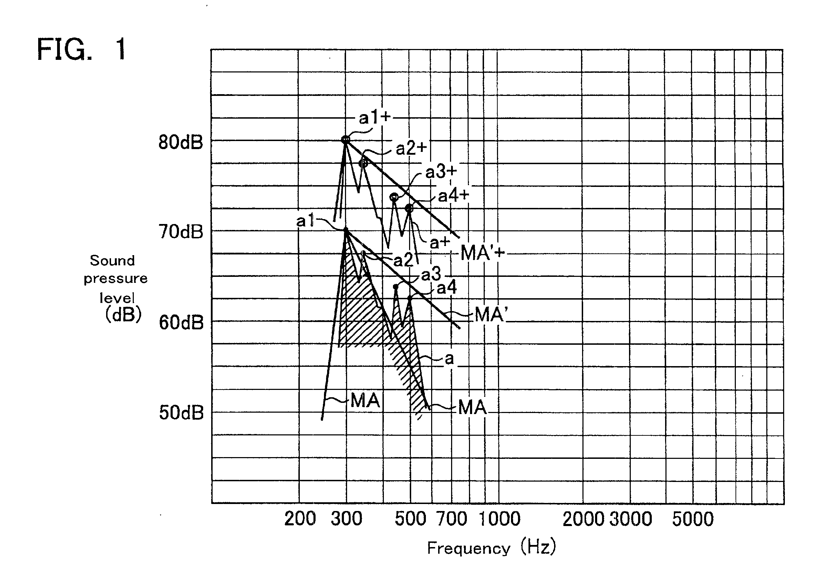

Fig. 1 is a diagram depicting the steps of auditory recognition for the sounds included in a short time block extracted from the sound flow as a sample, where the ordinate is the sound pressure level [dB], and the abscissa is the frequency [Hz].

In Fig. 1, "a" indicates a sound included in a short time block extracted from the sound flow as a sample, a+ is a sound stressing the sound a, a1 is the first formant of sound a, a2 is the second formant of sound a, a3 is the third formant of sound a, a4 is the fourth formant of sound a, a1+ is the first formant of sound a+, a2+ is the second formant of sound a+, a3+ is the third formant of sound a+, a4+ is the fourth formant of the sound a+, and MA, MA' and MA'+ respectively indicate the masking range.

The meaning of the above symbols are as follows.
a: frequency included in sound a and the level thereof,
a1: highest frequency in sound a and the level thereof,
a2: frequency to indicate the first peak of a frequency higher than a1, and the level thereof,
a3: frequency to indicate the second peak of a frequency higher than a1, and the level thereof,
a4: frequency to indicate the third peak of a frequency higher than a1, and the level thereof,
MA: masking range due to a1 (in the case of an individual without hearing impairment)
MA': masking range due to a1 (in the case of an individual with presbycusis)
a+: frequency of sound when a is stressed by 10 [dB] and the level thereof,
a1+: frequency at the highest level in a+ and the level thereof,
a2+: frequency to indicate the first peak of a frequency higher than a1+ and the level thereof,
a3+: frequency to indicate the second peak of a frequency higher than a1+ and the level thereof,
a4+: frequency to indicate the third peak of a frequency higher than a1+ and the level thereof,
MA'+: masking range due to a1+ (in the case of an individual with presbycusis)

The masking range MA of an individual without hearing impairment in sound a due to the first formant a1 influences frequencies lower than the first formant a1 in a narrow range, and influences frequencies higher than this in a wide range, where a sound at a lower level than the level of the masking range MA is masked by the first formant a1 and cannot be heard, but in the case of an individual without hearing impairment, the levels of the first formant a1, the second formant a2, the third formant a3, and the fourth formant a4 are higher than the level of the masking range MA, so all these sounds can be heard, and therefore sound a can be recognized.

However, when the auditory functions decline due to aging, the masking range due to the first formant a1 is expanded to MA', and as a result, the levels of the second formant a2, the third formant a3, and the fourth formant a4 become lower than the level of the masking range MA', and therefore cannot be detected.

If only the first formant a1 can be heard, recognizing the sound is impossible, so if the level of sound a is increased by 10 [dB] to be a+, the first formant a1 also increases by 10 [dB] and becomes a1+, but the masking range MA' increases to be the masking range MA'+, so the second formant a2+, the third formant a3+, and the fourth formant a4+, where the level increased by 10 [dB], are still masked by the masking range MA'+, and cannot be detected by the auditory senses.

Therefore, in the case of an individual with presbycusis, only a loud sound is heard, and the content of that sound cannot be accurately recognized no matter how high the level of sound is increased, so as described above, increasing the sound volume has no effect whatsoever on an individual whose level of masking range has become high.

The inventor of the present invention realized that the problem can be solved if acoustic signals are generated without stressing the first formant a1, but where the second formant a2, the third formant a3 . . . are stressed .

This means that if the level of the first formant a1 is not increased, then the level of the masking range MA does not increase, and clearly the levels of the second formant a2, the third formant a3 . . . are in a state which exceed the level of the masking range MA, so the sound a can be clearly detected, and if this sound is language, the content thereof can be understood perfectly. This analysis can be applied not only to an individual with presbycusis, but also to the above described individual with hearing impairment regarding foreign language.

Therefore a device which performs acoustic signal processing to implement the above mentioned analysis result is required, but this acoustic signal processor must operate based on the principle to be described next.

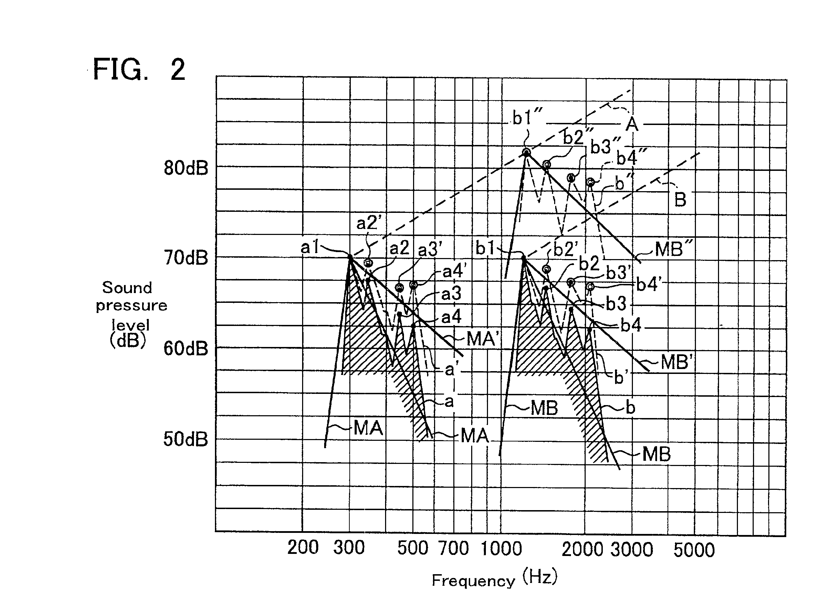

Fig. 2 is a diagram depicting the operation principle of the acoustic signal processing according to the present invention, where the ordinate is the sound pressure level [dB], and the abscissa is the frequency [Hz] respectively. Symbols the same as the symbols used in Fig. 1 indicate the same parts or have the same meaning as in Fig. 1.

The meaning of the symbols in Fig. 2 are as follows. Symbols described in Fig. 1, that is, symbols related to sound a, are the same as in the previous description, and are not described again here.
A: example of correction characteristic (curve) for sound a by this invention,
a': sound when sound a is corrected by the correction characteristic A,
a2': second formant of sound a',
a3': third formant of sound a',
a4': fourth formant of sound a',
b: frequency of sound included in a short time block extracted from the sound flow as a sample, and the level thereof,
b1: frequency at the highest level in sound b and the level thereof, and the first formant of sound b,
b2: frequency to indicate the first peak of a frequency higher than b1 and the level thereof, and the second formant of sound b,
b3: frequency to indicate the second peak of a frequency higher than b1 and the level thereof, and the third formant of sound b,
b4: frequency to indicate the third peak of a frequency higher than b1 and the level thereof, and the fourth formant of sound b,
MB: masking range due to b1 (in the case of an individual without hearing impairment),
MB': masking range due to b1 (in the case of an individual with presbycusis),
B: example of correction characteristic (curve) for sound b according to this invention,
b': sound when sound b is corrected by the correction characteristic B,
b2': second formant of sound b',
b3': third formant of sound b',
b4': fourth formant of sound b',
b": sound when sound b is corrected by the correction characteristic A,
b1'': first formant of sound b",
b2": second formant of sound b",
b3": third formant of sound b" ,
b4": fourth formant of sound b" ,
MB'': masking range due to b1" (in the case of an individual with presbycusis).

When sound a and sound b, which have different frequency components, are generated here in Fig. 2, sound a can be recognized if the auditory senses can detect the first formant of sound a along with the second formant a2, third formant a3, and fourth formant a4 thereof.

In the case of an individual without hearing impairment, the masking range due to the first formant a1 is MA, so the second formant, third formant, and fourth formant can be detected, but if the masking range is increased to MA' because of presbycusis, then the second formant, the third formant and the fourth formant cannot be detected, and therefore sound a can no longer be recognized.

In this state, the acoustic signal processing according to the present invention performs correction shown by the correction characteristic A, to be: second formant a2 → second formant a2', third formant a3 → third formant a3', and fourth formant a4 → fourth formant a4', so the second formant to the fourth formant exceed the masking range MA' of an individual with a hearing impairment, and sound a can be clearly recognized.

For sound b as well, an individual without hearing impairment can recognize sound b without error, since the levels of the second formant b2, the third formant b3, and the fourth formant b4, are higher than the masking range MB, but in the case of an individual with a hearing impairment, the masking range is MB', so sound b cannot be recognized.

However, the acoustic signal processing according to the present invention allows detection of the first formant b1 of sound b, and applies correction characteristic B to sound b to be: second formant b2 → second formant b2', third formant b3 → third formant b3', and fourth formant b4 → fourth formant b4', so the second formant to the fourth formant exceed the masking range MB' of an individual with hearing impairment, and sound b can be clearly recognized.

If a conventional tone control circuit is used, both the above mentioned correction characteristic A and correction characteristic B can be implemented, but it is not possible to automatically select the correction characteristic according to sound a or sound b.

Therefore if sound a and sound b are processed by correction characteristic A, an effect similar to the processing of the present invention may be implemented for sound a, but when sound b is processed [by a conventional method], the level increases to be sound b", which is much stronger than sound a, and this strength increases as the frequency increases, so a "noisy" high pitched sound is heard.

If sound a and sound b are processed by correction characteristic B, on the other hand, an effect similar to the present invention may be implemented for sound b, but no correction is performed for sound a, so sound a cannot be recognized.

Normally sound changes continuously from sound a to sound b, or from sound b to sound a, so correcting only a part of a sound is useless for the auditory senses to understand the sound, and only as in the present invention, when a sound is analyzed, an optimum correction characteristic is automatically selected, and correction is implemented for each analyzed sound, can the auditory senses be assisted in comprehension.

Since the auditory senses recognize not only human language but music, the sound of animals, wind and waves as well, because all are based on the same recognition process, so acoustic signal processing according to this invention can exhibit an improved effect in all cases for an individual with presbycusis where the masking range has expanded.

Sound processed by the acoustic processing of the present invention is heard as a sound which is different from the sound before processing if the listener is an individual without hearing impairment, but this sound is heard slightly clearer, and does not becomes a high pitched sound, which is unlike the case of amplifying the high tone area using a conventional tone control circuit.

A high pitch sound is generated because in the case of a tone control circuit, the target sound of correction often becomes a sound corrected by an incompatible correction characteristic, for example, sound b is corrected by the correction characteristic A as described in Fig. 2, where the first formant b1 is stressed up to the first formant b1'' of sound b", but in the case of the acoustic signal processing of the present invention, the first formant b1 does not change at all, only the second formant b2, the third formant b3 and the fourth formant b4 are stressed somewhat.

Therefore if acoustic signal processing according to the present invention is performed for the sounds of a television, for example, an individual with presbycusis can understand the sounds without a hearing aid at a volume which is not too loud for an individual without hearing impairment, or even if an individual without hearing impairment has difficulty in hearing the difference in the pronunciation of words when practicing a foreign language, they can differentiate the pronunciation, since pronunciation differences are stressed by performing acoustic signal processing according to the present invention for the sound, so it is possible to correct the pronunciation of a speaker, and the present invention is extremely effecting in learning a foreign language.

With the foregoing in view, an acoustic signal processor of one aspect of the invention comprises: means of determining a frequency band having the highest energy level out of the frequencies constituting the input acoustic signals, and a variable equalizer having a characteristic that maintains energy to be roughly (substantially) constant for the frequency bands lower than the frequency band determined by the above means, and increases the amplification degree of energy as the frequency increases to frequency bands higher than the frequency band determined by the above means.

The use of the above means allows implementing a device to process acoustic signals whereby acoustic information can be easily heard and accurately understood whether an individual has a hearing impairment or not.

In the drawings:
Fig. 1 is a diagram depicting the steps of auditory recognition for sounds included in a short time block extracted from the sound flow as a sample;
Fig. 2 is a diagram depicting the operation principle of the acoustic signal processor according to the present invention;
Fig. 3 is a block diagram depicting the key sections of the acoustic signal processor according to an embodiment of the present invention;
Figs. 4A-4C are diagrams depicting the operation of the acoustic signal processor shown in Fig. 3; and
Fig. 5 is a block diagram depicting the key sections of the acoustic signal processor according to another embodiment of the present invention.

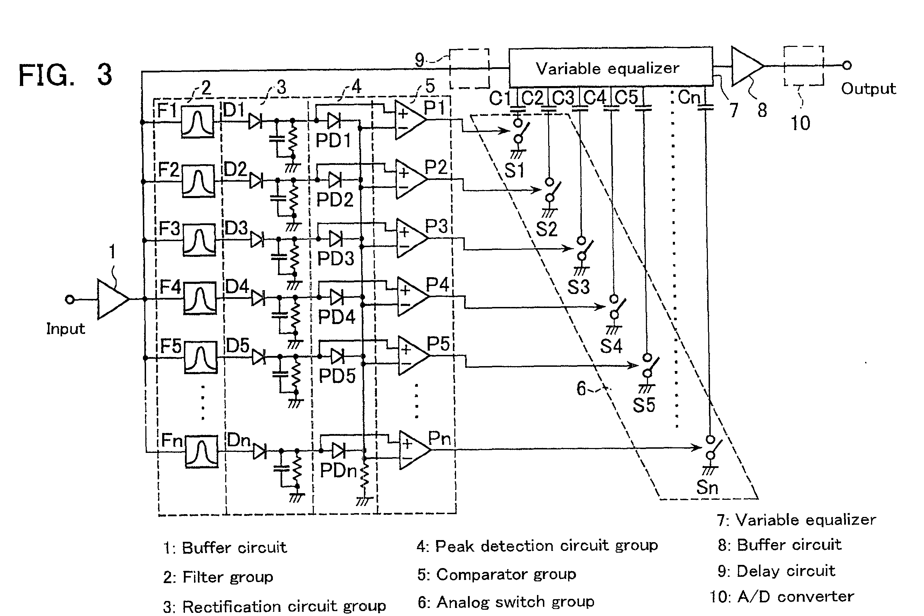

Fig. 3 is a block diagram depicting the key sections of the acoustic signal processor according to an embodiment of the present invention.

In Fig. 3, there are shown a buffer circuit 1 at the input side, a filter group 2, a rectification circuit group 3, a peak detection circuit group 4, a comparator group 5, an analog switch group 6, a variable equalizer 7, a buffer circuit 8 at the output side, a delay circuit 9, and an A/D converter 10, wherein the filter group 2 is comprised of filters F1, F2, F3 ... Fn, the rectification circuit group 3 is comprised of rectification circuits D1, D2, D3 . . . Dn, a capacitor and a resistor, the peak detection circuit group 4 is comprised of the peak detection diodes PD1, PD2, PD3 . . . PDn, the comparator group 5 is comprised of the comparators P1, P2, P3 . . . Pn, and the analog switch group 5 is comprised of the analog switches S1, S2, S3 . . . Sn, and C1, C2, C3 ... Cn are capacitors which function according to the characteristic of the variable equalizer 7.

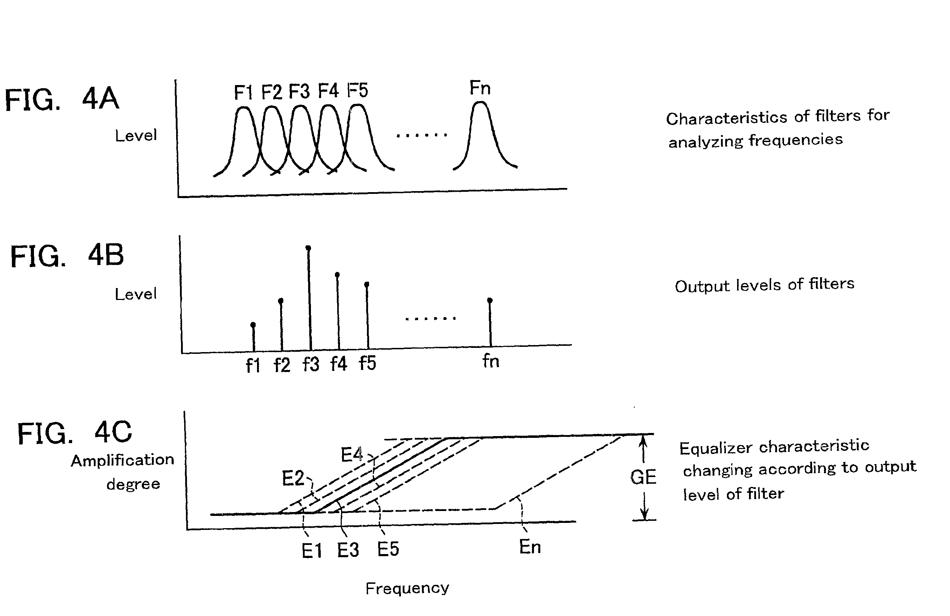

Figs. 4A, 4B and 4C are diagrams depicting the operation of the acoustic signal processor shown in Fig. 3, where Fig. 4A shows the filter characteristics of the filters F1 - Fn for analyzing frequencies, Fig, 4B shows the output levels of the filters F1 - Fn, and Fig. 4C shows the equalizer characteristic which changes according to the output level of a filter, wherein the abscissa is the frequencies for Figs. 4A, 4B and 4C, and the ordinate is the levels for Figs. 4A and 4B, and the amplification degree for Fig. 4C.

The acoustic signals which are input through the buffer circuit 1 are inserted to the filter group 1, and the acoustic signals separated into frequency components in the filter group 1 are output from each filter F1 - Fn.

The characteristics of the filter group 1 are continuous, as seen in Fig. 4A, so that the required frequency bands, about 200 [Hz] - 5 [kHz] for example, are covered, and Fig. 4B shows an example of the output levels from the filter group 1.

As Fig. 4B shows, in this case, the output level of the frequency f3, which is the output of the filter F3, is higher than the output levels of the other filters.

The peak detection circuit group 4 is for providing the highest output level among the outputs of the filters F1 - Fn to the negative side input terminal of the comparator group 5, and as Fig. 4B shows, the output of the frequency f3 is applied to the negative side input terminals of all comparators P1 - Pn when the level of the frequency f3 is the highest.

Therefore in the positive side input terminals of all comparators other than the comparator P3, the potential is lower than the negative side input terminals, output indicates " low" , and only in the comparator P3, potential is slightly higher in the positive input terminals for the amount of the drop in voltage of the diode PD3, and the output of the comparator P3 is therefore " high" .

The output of comparator P3 functions to determine the characteristics of the variable equalizer 7, and in this case, characteristic E3, shown by the continuous line in Fig. 4C, is selected. Characteristics E1 - En of the variable equalizer 7 change according to the output of comparators P1 - P n.

According to the characteristics determination process, analog switch S3 is turned ON by the output of comparator P3 to connect the comparator C3, and the operation characteristics of the variable equalizer 7 is set to characteristic E3, shown in Fig. 4C.

For the variable equalizer 7, as shown in Fig. 4C, even a passive filter, for example, can be used if characteristics are variable, but particularly an active filter in an IC format can be selected according to use, since characteristics can be easily controlled for many of these active filters, and a state variable filter, parametric filter, and switched capacitor filter, for example, can be used.

It is preferable that the characteristics of the variable equalizer 7 can be set according to the characteristics of the user, that is, according to the degree of hearing impairment of the individual, and the following characteristics are adjusted to implement optimization for a specific user.
[1] maximum correction amount (setting the [dB] value of GE shown in Fig. 4C),
[2] inclination of the correction characteristic (curve) (setting of the [dB] value per octave),
[3] correlation between the frequency analysis and correction characteristic (it may be more effective to finely adjust the filter frequency and rise frequency of the variable equalizer),
[4] correlation between the level of acoustic signals and the above [1], [2] and [3] (in some cases, it is better to change the correction coefficient depending on the level of signals).

When the characteristics of the variable equalizer 7 were changed according to the above mentioned standard, and the hearing improvement effect was tested for many individuals with minor and intermediate presbycusis, the result was effective for everyone tested, and it was also clarified that corrections made were in a range where little discomfort was experienced for individuals without hearing impairment.

If the sound of a television is processed by the acoustic signal processing according to the present invention, both individuals with presbycusis and those without hearing impairment can simultaneously hear sound set to a moderate volume, and good effects can be easily implemented by using the processing setting conditions at this time as standard settings.
(1) The maximum correction amount is 15 [dB] - 25 [dB].
(2) The inclination of the correction characteristic (curve) is 6 [dB/octave].
(3) The rise frequency of the variable equalizer is a frequency at the highest level in the frequency analysis of the input acoustic signals.
(4) The variable equalizer operates as described in Figs. 4A-4C, when the level of the input acoustic signals is around 60 [dB] SPL (Sound Pressure Level) - 80 [dB] SPL, but as the level of the input acoustic signals decreases, the rise frequency of the variable equalizer shifts to the low frequency side, where if the input acoustic signals are 40 [dB] SPL or less, the equalization characteristic at the lowest frequency is set regardless of the result of frequency analysis, and as the input acoustic energy level increases, the rise frequency of the variable equalizer shifts to the high frequency side, where if 100 [dB] SPL is exceeded, then the equalization characteristic at the highest frequency is set.

The equalization characteristics of the variable equalizer 7 must change according to the change of the input acoustic signal components, but a response time is required for level detection by the peak detection circuit group 4 for the output from the filter group 2, for the level comparison by the comparator group 5 and the setting of the equalization characteristic of the variable equalizer 7 respectively, and distortion may be generated if the response time is decreased.

In order to improve the response speed of the variable equalizer 7 without generating distortion, it is appropriate to set the response time to 5 [msec] or less when the signal processing characteristic of the variable equalizer 7 changes from the low frequency band to the high frequency band, and to 10 [msec] or less when the change is from the high frequency band to the low frequency band.

The delay time for processing in the variable equalizer 7 can be canceled by providing a delay time, the same as the delay time for processing in the variable equalizer 7, to the input acoustic signals, and for this, a delay circuit 9, for generating an appropriate delay, can be inserted at the input side of the variable equalizer 7, as shown by the broken line in Fig. 3, or input acoustic signals may be digitized so that problems with delay time can be canceled by performing delay time cancellation processing on memory.

The acoustic signal processing according to the present invention can be applied to all electric (electronic) equipment for generating sound which individuals can recognize as information, and may be built into such equipment and turned ON/OFF when necessary, or can exhibit a higher effect by usage with a volume controller, tone controller, and automatic volume control circuit.

Also as Fig. 3 shows, acoustic signals to be played back become sounds which are very easy to hear for individuals with and without hearing impairment if an A/D converter 10 is inserted at the output side of the variable equalizer 7, output acoustic signals of the variable equalizer 7 are digitized, the digitized acoustic signals are recorded on such recording media as DVD, CD, FD, magnetic tape and magnetic disk, and the recording medium is set into the playback unit and acoustic signals are played back, and these functions and effects are the same even when digitized acoustic signals are transmitted to a remote area using an appropriate communication means.

In the above embodiment, the case when acoustic signal processing is performed using the variable equalizer 7 was described, but this can be performed using other means.

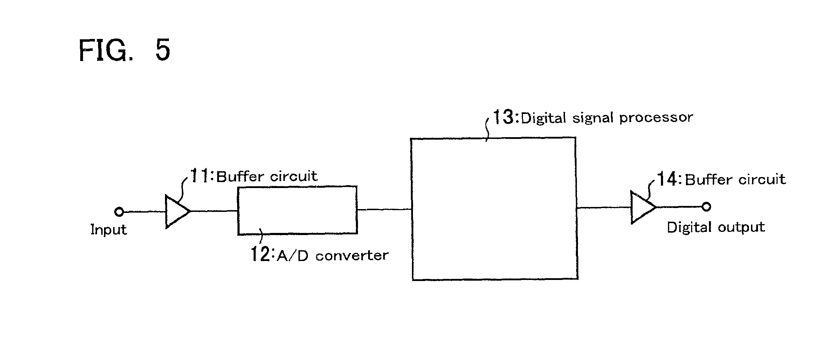

Fig. 5 is a block diagram depicting the key sections of the acoustic signal processor according to another embodiment of the present invention, and in Fig. 5, there are shown a buffer circuit11, an A/D converter 12, a digital signal processor 13, and a buffer circuit 14.

For the digital signal processor 13, an MPU (Micro-Processing Unit) or a DSP (Digital Signal Processor) can be used.

In the acoustic signal processor in Fig. 5, analog input acoustic signals are digitized using the A/D converter 12, and the digitized acoustic signals are computed by the digital signal processor 13, so as to implement processing having the same effect as the processings described in Fig. 3 and Figs. 4A-4C.

Computed acoustic signals can be played back and listened to by an ordinary digital playback unit, and, as described for the embodiment using the variable equalizer 7, the processed acoustic signals can also be recorded on a recording medium and played back when necessary or transmitted to a remote area.

Basically the acoustic signal processing according to the present invention comprises a step of determining a frequency band having the highest energy level out of the frequencies constituting the input acoustic signals, and an equalizing step which maintains the energy roughly at a constant level for the frequency bands lower than the frequency band determined by this means, and increases the amplification degree of the energy as the frequency increases for the frequency bands higher than the frequency band determined by this means.

By this configuration, a device, which allows the processing of acoustic signals such that acoustic information can be easily heard and accurately understood for individuals with or without hearing impairment, can be implemented.

## Claims

1. An acoustic signal processor comprising:
a determination unit for determining a frequency band having the highest energy level out of the frequency bands constituting the input acoustic signals; and
a variable equalizer having a characteristic for maintaining the energy level substantially at a constant level for frequency bands lower than the frequency band determined by said determination unit, and for increasing the amplification degree of the energy level as the frequency increases for the frequency bands higher than the frequency band determined by said determination unit.

2. The acoustic signal processor according to Claim 1, wherein said variable equalizer has a 6 [dB]/octave high pass filter characteristic.

3. The acoustic signal processor according to Claim 1 or 2, wherein a delay circuit for providing a delay time, corresponding to a response time unique to said variable equalizer, to the input acoustic signals, is inserted at the input side of the variable equalizer.

4. The acoustic signal processor according to Claim 1, 2, or 3, wherein an A/D converter is inserted at the output side of said variable equalizer.

5. The acoustic signal processor according to any preceding claim, wherein the rise frequency of the variable equalizer shifts to the low frequency side as the energy level of the input acoustic signals decreases, and the rise frequency of the variable equalizer shifts to the high frequency side as the energy level of the input acoustic signals increases.

6. The acoustic signal processor according to any preceding claim, wherein the amplification degree of the variable equalizer is in the 15 [dB] to 25 [dB] range.

7. The acoustic signal processor according to Claim 3, wherein the response time of said variable equalizer is 5 [msec] or less when the high pass filter characteristic shifts to the high frequency side, and is 10 [msec] or less when the high pass filter characteristic shifts to the low frequency side.

8. An acoustic signal processor, comprising:
an A/D converter for digitizing input acoustic signals; and
a processor comprised of a micro-processor unit or a digital signal processor for generating digital acoustic signals, performing frequency analysis on the digital acoustic signals from said A/D converter, and amplifying the frequency bands higher than the frequency band at which the energy level is the highest.

9. A program which when run on a micro-processor unit or a digital signal processor, causes the same to implement the acoustic signal processor of any preceding claim.

10. A method of processing acoustic signals comprising the steps of:
determining a frequency band having the highest energy level out of the frequency bands constituting the acoustic signals; and
equalizing the acoustic signals so as to maintain the energy level substantially at a constant level for frequency bands lower than the determined frequency band, and to increase the amplification degree of the energy level as the frequency increases for the frequency bands higher than the determined frequency band.
